# EUROPEAN PATENT APPLICATION

(11) **EP 0 772 266 A1**
(43) Date of publication of application: **07.05.1997**
(21) Application number: 96116890.3
(22) Date of filing: 21.10.1996
(51) Int. Cl.: H01S 3/085

(54) **Low resistance top emitting ridge VCSEL and method of fabrication**

(30) Priority: 30.10.1995 US 550148
(71) Applicant: MOTOROLA, INC., Schaumburg, IL 60196 (US)
(72) Inventor: Shieh, Chan-Long, Paradise Valley, Arizona 85253 (US); Jiang, Wenbin, Phoenix, Arizona 85044 (US); Lebby, Michael S., Apache Junction, Arizona 85219 (US)
(74) Representative: Morgan, Marc

(57) **Abstract**

A high efficiency vertical cavity surface emitting laser (30) including first and second mirror stacks (31, 37) with an active region (32) sandwiched therebetween having an optical mode. The second mirror stack (37) is formed into a mesa with exposed end surface and having outer sidewalls and a diametric size substantially greater than the optical mode. A portion (38) of the second mirror stack (37) adjacent the active region (32) has a reduced electrical conductance so as to channel operating current from the second mirror stack (37) into the optical mode of the active region (32).

## Description

### Background of the Invention

### Field of the Invention

This invention relates to vertical cavity surface emitting lasers and more specifically to vertical cavity surface emitting lasers with a mesa structure and a light emission window on the surface of the mesa.

### Prior Art

Vertical cavity surface emitting lasers are well known, and are formed in a wide variety of configurations. However, the basis for the laser in virtually all configurations is an active area sandwiched between two mirror stacks. The laser is activated by driving an electrical current through the two mirror stacks and the active area. This is generally accomplished by placing a first electrode across the mirror stack at one end of the laser and a second electrode across the other mirror stack at the other end of the laser. One of the electrodes generally defines a central opening therethrough for the emission of light.

For maximum efficiency and in order to sustain a single lateral mode, it is necessary that the major portion of the current be injected into the active region in the optical mode or lasing area. Current outside the lasing area is generally wasted or produces lasing which is wasted.

To overcome this problem, many devices employ a mesa, through which the current is injected, having a size closely corresponding to the optical mode. While this reduces wasted current or lasing, it results in an increase in series resistance, reducing efficiency. Also, because the area of the top electrode is reduced with the reduction in the diameter of the mesa, series resistance is further increased. While the size of the mesa is reduced, the emission window remains the same, causing the reduction in the area of the electrode.

In order to drive the vertical cavity surface emitting laser with a conventional current source laser driver to GHz, the series resistance of the device must be reduced. The specific contact resistance of the top mirror stack and the top electrode depends on the doping concentration. However, the doping concentration is constrained by the need to minimize the optical loss due to free carrier absorption. Therefore, optimized doping alone can not achieve a series resistance low enough for GHz operation.

It would be highly advantageous, therefore, to remedy the foregoing and other deficiencies inherent in the prior art.

Accordingly, it is an object of the present invention to provide improvements in vertical cavity surface emitting lasers.

Another object of the invention is to provide a vertical cavity surface emitting laser with a current path closely coordinated with the optical mode.

And another object of the invention is to provide a vertical cavity surface emitting laser with a current path closely coordinated with the optical mode and having reduced series resistance.

### SUMMARY OF THE INVENTION

Briefly, to achieve the desired objects of the instant invention in accordance with a preferred embodiment thereof, provided is a high efficiency vertical cavity surface emitting laser including first and second mirror stacks with an active region sandwiched therebetween. A portion of the second mirror stack adjacent the active region has a reduced electrical conductance so as to channel operating current from the second mirror stack into an optical mode of the active region.

Also provided is a method of fabricating a VCSEL wherein the portion with reduced electrical conductance is produced by etching or oxidizing one or a few mirror pairs adjacent the active region.

### BRIEF DESCRIPTION OF THE DRAWINGS

The foregoing and further and more specific objects and advantages of the instant invention will become readily apparent to those skilled in the art from the following detailed description of a preferred embodiment thereof taken in conjunction with the drawings, in which:
FIG. 1 is a partial sectional view of a conventional vertical cavity surface emitting laser;
FIG. 2 is a sectional view of an intermediate product in the process of fabricating a vertical cavity surface emitting laser in accordance with the teachings of the present invention; and

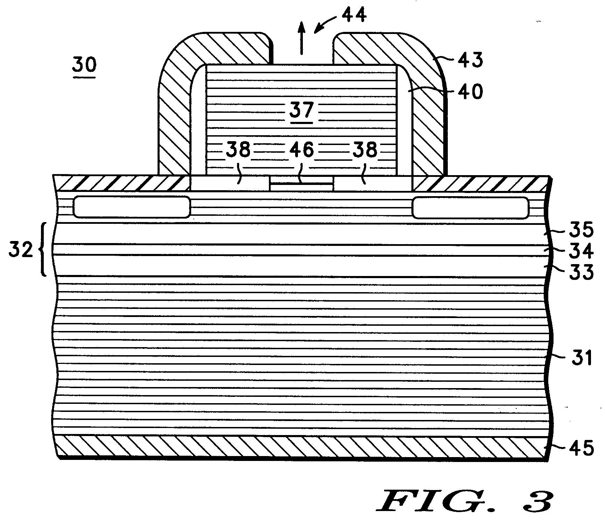

FIG. 3 is a sectional view of a vertical cavity surface emitting laser constructed in accordance with the teachings of the present invention.

### DETAILED DESCRIPTION OF THE PREFERRED EMBODIMENT

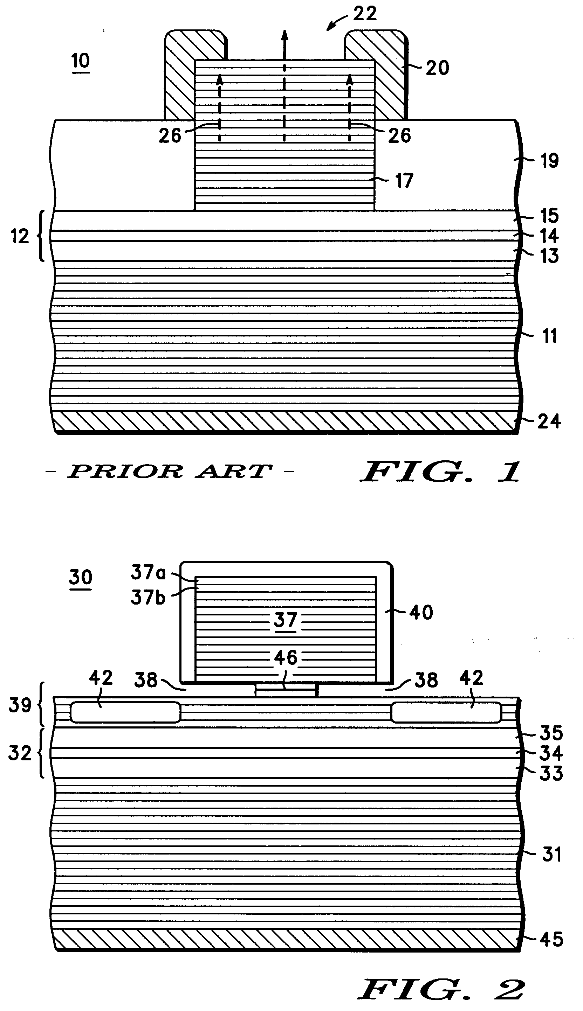

Turning now to the drawings in which like reference characters indicate corresponding elements throughout the several views, attention is first directed to Fig. 1 which illustrates a vertical cavity surface emitting laser (VCSEL) generally designated 10. VCSEL 10 includes a first mirror stack 11, an active region 12 having a first cladding layer 13, an active layer 14 (such as quantum wells and the like) and a second cladding layer 15, and a second mirror stack 17. Second mirror stack 17 is etched, or selectively deposited, to form a mesa-like structure. An electrical contact 20 is formed in contact with at least the upper end of second mirror stack 17. Electrical contact 20 defines a window 22 for the emission of light from VCSEL 10 through second mirror stack 17. A second electrical contact 24 is positioned over the lower surface of first mirror stack 11.

An operating voltage applied across contacts 20 and 24 produces a current flow through VCSEL 10 which produces the lasing action as is well known. In general, because of the position of electrical contact 20 on the surface of second mirror stack 17, current flows throughout the mesa-like structure of second mirror stack 17 and lasing is supported wherever current flows. Since current outside the optical mode is wasted and may even interfere with proper operation of the VCSEL, typically, the diametric size of the mesa is dependent upon the mode of operation of the VCSEL, with the diameter closely matching the mode of operation. In this manner, current flow is generally limited to the mode of operation. The problem is that series resistance, resulting in part from the reduced size of second mirror stack 17, is too high to operate VCSEL 10 in GHz. Conventionally, in order to sustain a single lateral mode, the size of the mesa is approximately 10 microns. Further increasing resistance is the reduced area of contact 20 resulting from the inclusion of emission window 22. These factors create a lower limit of the series resistance of a VCSEL having a 10 micron mesa to approximately 100 Ohms. In order to drive the VCSEL with a conventional current source laser driver to GHz, the series resistance must be reduced further.

Referring to FIG. 2, a vertical cavity surface emitting laser 30 (VCSEL) embodying the present invention is illustrated. VCSEL 30 includes a first mirror stack 31, an active region 32 having a first cladding layer 33, an active layer 34 and a second cladding layer 35, and a second mirror stack 37. Second mirror stack 37 is etched, or selectively deposited, to form a mesa-like structure, as described above. However, in the present invention, the series resistance of VCSEL 30 is lowered by increasing the diametric size of second mirror stack 37. Increasing the diametric size of the mesa-like structure greatly reduces resistance, but also allows current flow into active region 32 outside the optical mode. To control the current flow into active region 32, the electrical conductance of a portion 38 adjacent active region 32 is reduced.

Portion 38 includes the outer circumference of one or more mirror pairs adjacent active region 32. This is preferably accomplished by etching second mirror stack 37 to form the mesa-like structure, leaving one or more mirror pairs 39 (illustrated in broken lines) unetched. A dielectric layer 40 is deposited over the mesa-like structure and etched back, leaving a mask covering the sides and top surface thereof. The Remaining one or more mirror pairs 39 are then etched, preferably using an RIE or wet etch, well known in the art. This leaves portion 38 at the base of the mesa-like structure uncovered with dielectric layer 40, and susceptible to etching or oxidation.

Second mirror stack 37 is formed predominantly of alternating low and high aluminum containing layers 37a and 37b of AlGaAs distributed Bragg reflectors. Alternating layer 37a and 37b provide alternating high and low indexes of refraction. In this specific embodiment, alternating layers 37a and 37b of low and high aluminum containing AlGaAs adjacent active region 32 are selectively oxidized in accordance with the aluminum content. The layer of the mirror pair having a high concentration of aluminum is readily oxidized, reducing its electrical conductance. The oxidation in this embodiment is accomplished by subjecting the exterior walls of the mesa-like structure to a nitrogen ambient containing water moisture. In this ambient the natural oxidation of the aluminum causes high resistance portion 38 within the mirror pairs adjacent the active region. Alternatively, portion 38 of the mirror pairs may be removed by etching. Selective wet etching is performed by using diluted HF or diluted HCL. The majority of second mirror stack 37 is protected from the etch or oxidation by dielectric layer 40. Only one or a few mirror pairs adjacent active region 32 are susceptible to the etch or oxidation. The optical mode and threshold current can be controlled by the degree of undercut or oxidation without adverse impact on the series resistance.

The low electrical conductance of portion 38 also helps enhance the reliability and lifetime of VCSEL 10 by allowing undoped second cladding layer 35 to be fully depleted, preventing migration of both defects and carriers into active layer 34 which causes degradation. In some specific applications some mirror pairs may be retained below portion 38. Implants 42 may optionally be formed in these remaining pairs of second mirror stack 37 to aid in preventing migration of defects and carriers. It will be understood that portion 38 is still adjacent to active region 32 even though a few mirror pairs may intervene.

In addition to the depletion of carriers in undoped second cladding layer 35 and the optional incorporation of implants 42, a monolayer of an indium based alloy (e.g. InAlGaP, InAs, etc.), designated 46, can be optionally included in the opening defined by portion 38. All of the operating current flowing in VCSEL 30 flows through the opening defined by portion 38 and, thus, any defects carried by the current must pass through the opening. It has been found that a monolayer of an indium based alloy substantially prevents defects from passing therethrough. Thus, in applications which justify the additional steps of forming a monolayer of indium based alloy in or between mirror pairs making up the portion 38 and the opening defined thereby, this feature produces additional reduction in defects migrating to the active area and, therefore, further increases the life of VCSEL 30.

The size of portion 38 which is removed or oxidized depends on the overall diametric size of the mesa, and the desired operating mode. Preferably, portion 38 is the diameter of the mirror pairs outside the desired optical mode. Thus, the reduced electrical conductance of portion 38 results in a funneling of the current into the active region at the optical mode. To achieve a low resistance, the diametric size of the mesa is substantially larger than the optical mode of the VCSEL. In the preferred embodiment, the diametric size of the mesa is at least twice as large as the operating mode.

An electrical contact 43 is formed in contact with at least the upper end of second mirror stack 37. Electrical contact 43 defines a window 44 for the emission of light from VCSEL 30 through second mirror stack 37. A second electrical contact 45 is positioned over the lower surface of first mirror stack 31. The area of electrical contact 43 is increased proportional to the increase in the diametric size of the mesa-like structure. Since window 44 for the emission of light remains the same, generally corresponding to the optical mode, the larger the diametric size of the mesa-like structure, the larger the area of contact 43. This gives a much greater area for contact without shadowing the emitting light, thereby reducing series resistance due to ohmic contact.

Thus, current injection is controlled, with current injected into active region 32 in the optical mode, and series resistance is greatly reduced due to the large diametric size of second mirror stack 37 and the correspondingly large area of contact 43.

Various changes and modifications to the embodiments herein chosen for purposes of illustration will readily occur to those skilled in the art. To the extent that such modifications and variations do not depart from the spirit of the invention, they are intended to be included within the scope thereof which is assessed only by a fair interpretation of the following claims.

Having fully described the invention in such clear and concise terms as to enable those skilled in the art to understand and practice the same, the invention claimed is:

## Claims

1. A high efficiency vertical cavity surface emitting laser characterized by:
first and second mirror stacks (31, 37) with an active region (32) sandwiched therebetween having an optical mode;
the second mirror stack (37) being formed into a mesa with exposed end surface and having outer sidewalls and a diametric size substantially greater than the optical mode;
a portion (38) of the second mirror stack (37) adjacent the active region (32) having a reduced electrical conductance so as to channel operating current from the second mirror stack (37) into the optical mode of the active region (32); and
an electrical contact (43) at least on the end surface of the mesa, the electrical contact (43) defining a central light emission window (44).

2. A high efficiency vertical cavity surface emitting laser as claimed in claim 1 further characterized in that the portion (38) of the second mirror stack (37) adjacent the active region (32) includes an outer periphery of one layer of a mirror pair adjacent the active region (32).

3. A high efficiency vertical cavity surface emitting laser as claimed in claim 1 further characterized in that the second mirror stack (37) includes alternating layers of high and low aluminum content AlGaAs forming mirror pairs and the portion (38) with reduced electrical conductance includes an outer periphery of the high aluminum content AlGaAs layer of the mirror pair adjacent the active region (32).

4. A high efficiency vertical cavity surface emitting laser as claimed in claim 3 further characterized in that the portion (38) with reduced electrical conductance includes an oxidized outer periphery of the high aluminum content AlGaAs layer adjacent the active region (32).

5. A high efficiency vertical cavity surface emitting laser as claimed in claim 3 further characterized in that the portion (38) with reduced electrical conductance includes a removed outer periphery of the high aluminum content AlGaAs layer adjacent the active region (32).

6. A high efficiency vertical cavity surface emitting laser as claimed in claim 1 further characterized in that the diametric size of the mesa is at least twice as large as the optical mode.

7. A high efficiency vertical cavity surface emitting laser as claimed in claim 1 further characterized in that a monolayer of indium based alloy is positioned in the optical mode of the active region (32).

8. A method of fabricating a high efficiency vertical cavity surface emitting laser characterized by the steps of:
forming first and second mirror stacks (31, 37) with an active region (32) sandwiched therebetween and having an optical mode;
forming the second mirror stack (37) into a mesa with exposed end surface and having outer sidewalls and a diametric size substantially greater than the optical mode;
reducing the electrical conductance of a portion (38) of the second mirror stack (37) adjacent the active region (32) so as to channel operating current from the second mirror stack (37) into the optical mode of the active region (32); and
forming an electrical contact (43) at least on the end surface of the mesa, the electrical contact (43) defining a central light emission window (44).

9. A method of fabricating a high efficiency vertical cavity surface emitting laser as claimed in claim 8 wherein the step of reducing the electrical conductance of a portion (38) of the second mirror stack (37) adjacent the active region (32) is further characterized by reducing the electrical conductance of an outer periphery of one layer of a mirror pair adjacent the active region (32).

10. A method of fabricating a high efficiency vertical cavity surface emitting laser as claimed in claim 9 wherein the step of forming the second mirror stack (37) is further characterized by depositing alternating layers of high and low aluminum content AlGaAs forming mirror pairs.
